# EUROPÄISCHE PATENTANMELDUNG

(11) **EP 4 814 774 A1**
(43) Veröffentlichungstag der Anmeldung: **30.09.2026**
(21) Anmeldenummer: 25166233.4
(22) Anmeldetag: 26.03.2025
(51) Int. Cl.: G06F 30/17, G05B 19/4069, G05B 19/4097

(54) **VERFAHREN ZUM ERGÄNZEN VON INFORMATIONEN IN EINEM DIGITALEN KONSTRUKTIONSMODELL EINES WERKZEUGS**

(71) Anmelder: Technische Hochschule Deggendorf, in Vertretung des Freistaates Bayern, 94469 Deggendorf (DE)
(72) Erfinder: Gansauge, Ludwig, 94469 Deggendorf (DE)
(74) Vertreter: Wolf, Gerhard

(57) **Zusammenfassung**

Computerimplementiertes Verfahren zum Ergänzen von Informationen in einem digitalen Konstruktionsmodell eines Werkzeugs, das zur Fertigung eines Bauteils verwendet wird, wobei das Verfahren folgende Schritte umfasst:

- Bereitstellen eines digitalen Konstruktionsmodells des zu fertigenden Bauteils, wobei das Bauteil zumindest einen Bauteilbereich aufweist, dem Code einer Bauteil-Codierungssystematik zugeordnet ist, wobei dem Bauteilbereich mittels dem Code der Bauteil-Codierungssystematik eine Zusatzinformation zugeordnet ist, die ein technisches Merkmal des Bauteilbereichs definiert, das von dem Werkzeug abhängig ist, mit dem das Bauteil gefertigt wird (S10);

- Bereitstellen eines digitalen Konstruktionsmodells zumindest eines Werkzeugteils des Werkzeugs, das zur Fertigung des Bauteils verwendet wird (S11);

- zumindest teilautomatisiertes Zuordnen eines Codes einer Werkzeug-Codierungssystematik zu einem Bereich des digitalen Konstruktionsmodells des Werkzeugteils basierend auf der Zusatzinformation, die dem Bauteilbereich mittels des Codes der Bauteil-Codierungssystematik zugeordnet ist, wobei durch den Code der Werkzeug-Codierungssystematik ein technisches Merkmal des Werkzeugteils definiert wird und wobei das Werkzeugteil und der Bauteilbereich miteinander prozesstechnologisch derart verbunden sind, dass das technische Merkmal des Bauteilbereichs durch das technische Merkmal des Bereichs des Werkzeugteils beeinflusst wird (S12);

- zumindest teilautomatisiertes Ergänzen des Bereichs des digitalen Konstruktionsmodells des Werkzeugteils um den Code der Werkzeug-Codierungssystematik, der diesem Bereich des digitalen Konstruktionsmodells des Werkzeugteils zugeordnet wurde (S13).

## Beschreibung

Die Erfindung betrifft ein computerimplementiertes Verfahren zum Ergänzen von Informationen in einem digitalen Konstruktionsmodell eines Werkzeugs, mittels dem ein Bauteil gefertigt wird.

Computerprogramme zur Erzeugung eines digitalen Konstruktionsmodells eines Bauteils sind grundsätzlich bekannt. Insbesondere sind CAD-Programme (CAD: computer-aided design) bekannt, mittels denen digitale Konstruktionsmodelle eines herzustellenden Bauteils oder eines aus mehreren Bauteilen zusammengesetzten Produkts erstellt werden können.

Des Weiteren ist es bekannt, bei der Konstruktion eines Bauteils im CAD-System PMI-Informationen (PMI: Product Modelling Information) hinzuzufügen. PMI-Informationen können Informationen umfassen, die zur Fertigung eines Bauteils nötig sind, beispielsweise Informationen zu Oberflächengüte, Materialien, Toleranzen etc. PMI-Informationen werden als Anmerkungen bzw. Label zu den jeweiligen Bereichen des Bauteils hinzugefügt, d.h. sind damit nicht unmittelbarer Bestandteil des Konstruktionsmodells.

Aus der anmeldereigenen deutschen Patentanmeldung DE 10 2023 105 471 A1 ist ein Verfahren und System zur Steuerung eines Fertigungsprozesses eines Bauteils bekannt geworden. Dabei wird mittels Farben, die in dem digitalen Konstruktionsmodell eines Bauteils enthalten sind, und einer Farbcodierungssystematik, die einer Farbe eines Farbtableaus eine Geometriezusatzinformation zuordnet, eine Zusatzinformation bereitgestellt, die bei der Steuerung des Fertigungsprozesses maschinell ausgelesen werden kann, so dass basierend auf dieser Zusatzinformation eine Steuerung der Bearbeitungsmaschine möglich ist.

Zur maschinellen Herstellung eines Bauteils werden häufig spezielle Werkzeuge benötigt. So wird beispielsweise zur Herstellung eines Stanzteils ein Stanzwerkzeug benötigt. Weitere Beispiele sind Umformwerkzeuge oder Urformwerkzeuge.

Bislang erfolgt die Konstruktion eines Werkzeugs derart, dass ein Konstrukteur die technischen Spezifikationen, die ein Bauteil, das mittels des Werkzeugs gefertigt werden soll, erfüllen muss, aus dem Konstruktionsmodell des Bauteils herausliest und aufgrund seines Fachwissens das Werkzeug derart konstruiert, dass mit diesem Werkzeug ein Bauteil fertigbar ist, das die geforderten technischen Spezifikationen erfüllt.

Dieser Vorgang ist zum einen aufwändig, zum anderen sehr stark von den jeweiligen Kenntnissen und Fähigkeiten des Konstrukteurs abhängig, der das digitale Konstruktionsmodell des Werkzeugs erstellt, so dass die Spezifikationen des Bauteils, das mit dem Werkzeug gefertigt wird, oft erst nach mehrmaliger Überarbeitung erfüllt werden können.

Ausgehend hiervon ist es Aufgabe der Erfindung, ein Verfahren anzugeben, mittels dem ein digitales Konstruktionsmodell eines Werkzeugs mit geringem Aufwand und mit hoher Zuverlässigkeit erstellbar ist.

Die Aufgabe wird durch ein Verfahren mit den Merkmalen des unabhängigen Patentanspruchs 1 gelöst. Bevorzugte Ausführungsformen sind Gegenstand der Unteransprüche. Ein Computerprogramm, mittels dem ein Konstruktionsmodell eines Werkzeugs um Informationen ergänzbar ist, ist Gegenstand des nebengeordneten Patentanspruchs 15.

Gemäß einem ersten Aspekt bezieht sich die Erfindung auf ein computerimplementiertes Verfahren zum Ergänzen von Informationen in einem digitalen Konstruktionsmodell eines Werkzeugs, das zur Herstellung und/oder Fertigung eines Bauteils verwendet wird.

Das Verfahren umfasst folgende Schritte:
Zunächst wird ein digitales Konstruktionsmodell des zu fertigenden Bauteils bereitgestellt. Das Bauteil weist zumindest einen Bauteilbereich auf, dem ein Code einer Bauteil-Codierungssystematik zugeordnet ist. Der Code kann beliebige Codewerte aufweisen, beispielsweise einen mehrstelligen Code, der Buchstaben und/oder Ziffern umfasst. Dem Bauteilbereich wird mittels des Codes der Bauteil-Codierungssystematik eine Zusatzinformation zugeordnet, die ein technisches Merkmal des Bauteilbereichs definiert. Das technische Merkmal ist von dem Werkzeug abhängig, mit dem das Bauteil gefertigt wird.

Die Bauteil-Codierungssystematik kann insbesondere eine Bauteil-Farbcodierungssystematik und der Code eine Farbe sein, d.h. die Bauteil-Farbcodierungssystematik kodiert mittels einer Vielzahl von Farben Zusatzinformationen, die ein oder mehrere technische Merkmale des Bauteilbereichs oder des Bauteils spezifizieren.

Zudem wird ein digitales Konstruktionsmodell zumindest eines Werkzeugteils des Werkzeugs bereitgestellt, wobei das Werkzeug zur Fertigung des Bauteils verwendet wird.

Basierend auf der Zusatzinformation, die dem Bauteilbereich mittels des Codes der Bauteil-Codierungssystematik zugeordnet ist, wird zumindest teilautomatisiert ein Code einer Werkzeug-Codierungssystematik zu einem Bereich des digitalen Konstruktionsmodells des Werkzeugteils zugeordnet. Durch den Code der Werkzeug-Codierungssystematik wird ein technisches Merkmal des Werkzeugteils definiert. Das Werkzeugteil und der Bauteilbereich sind prozesstechnologisch derart miteinander verbunden, dass das technische Merkmal des Bauteilbereichs durch das technische Merkmal des Bereichs des Werkzeugteils beeinflusst wird. Insbesondere bedingt das technische Merkmal des Werkzeugteils, dass eine technische Anforderung, die durch die Zusatzinformation des Bauteilbereichs definiert ist, erfüllt wird.

Die Werkzeug-Codierungssystematik ist insbesondere eine Werkzeug-Farbcodierungssystematik und der Code ist eine Farbe, d.h. die Werkzeug-Farbcodierungssystematik kodiert mittels einer Vielzahl von Farben Zusatzinformationen, die ein oder mehrere technische Merkmale des Werkzeugteils spezifizieren.

Zuletzt wird der Bereich des digitalen Konstruktionsmodells des Werkzeugteils um den Code der Werkzeug-Codierungssystematik, die diesem Bereich des digitalen Konstruktionsmodells des Werkzeugteils zugeordnet wurde, zumindest teilautomatisiert ergänzt. Für den Fall, dass der Code eine Farbe ist, wird beispielsweise der Bereich des Konstruktionsmodells des Werkzeugteils mit dieser Farbe eingefärbt. Der technische Vorteil des Verfahrens besteht darin, dass das digitale Konstruktionsmodell des Werkzeugs, mittels dem ein Bauteil hergestellt wird, automatisch um Informationen ergänzt wird, die nötig sind, um die Anforderungen zu erfüllen, die an das Bauteil gestellt werden. Dadurch wird der Aufwand zur Erstellung des Konstruktionsmodells des Werkzeugs entscheidend reduziert, da eine Informationsvererbung erfolgt. Des Weiteren können iterative Änderungsschleifen im Vorserienprozess des Werkzeugs verhindert oder zumindest reduziert werden. Zudem wird erreicht, dass das Werkzeug die gestellten Eigenschaften mit höherer Zuverlässigkeit erfüllt. Durch die vorzugsweise erfolgende Kodierung der Informationen über Farben von Farbcodierungssystematiken wird zudem die Möglichkeit geschaffen, die Informationen durchgängig über die Schnittstellen zwischen dem Konstruktionsmodell des Bauteils und dem hiervon unabhängigen Konstruktionsmodell des Werkzeugs qualifiziert zu übertragen. Zuletzt bietet das Verfahren den Vorteil einer schnelleren und treffsicheren Kostenkalkulation des Bauteils und dem für die Fertigung des Bauteils nötigen Werkzeugs, da die Merkmalsbeziehungen, die zwischen einem Merkmal des Bauteils und einem Merkmal des Werkzeugs bestehen, zu Kostenbeziehungen führen, die auch dazu verwendet werden können, die Bauteilkosten inklusive Werkzeugkosten schneller und exakter zu kalkulieren.

Gemäß einem Ausführungsbeispiel gibt das technische Merkmal des Bauteilbereichs, das durch die Zusatzinformation definiert wird, einen definierten Stanzgrat an. Das technische Merkmal des Werkzeugteils, das durch den Code, der dem Bereich des Werkzeugteils zugeordnet wird, definiert wird, gibt ein definiertes Passungsspiel des Werkzeugs an. Damit kann aus der kodierten Information zum Stanzgrat, der in dem digitalen Konstruktionsmodell des Bauteils enthalten ist, dem Werkzeugteil, das die Herstellung dieses Bauteilbereichs mitwirkt, ein kodiertes Passungsspiel zugeordnet werden, mittels dem dieser geforderte Stanzgrat erzielbar ist.

Gemäß einem Ausführungsbeispiel gibt das technische Merkmal des Bauteilbereichs, das durch die Zusatzinformation definiert wird, eine definierte Oberflächeneigenschaft des Bauteilbereichs an. Das technische Merkmal des Werkzeugteils, das durch den Code, der dem Bereich des Werkzeugteils zugeordnet wird, definiert wird, gibt eine definierte Oberflächeneigenschaft des Werkzeugteils an. Damit kann aus der kodierten Information zur Oberflächeneigenschaft des Bauteilbereichs, die in dem digitalen Konstruktionsmodell des Bauteils enthalten ist, dem Werkzeugteil, das die Herstellung dieses Bauteilbereichs mitwirkt, eine kodierte Oberflächeneigenschaft zugeordnet werden, mittels der die geforderte Oberflächeneigenschaft des Bauteilbereichs erzielbar ist.

Gemäß einem Ausführungsbeispiel gibt das technische Merkmal des Bauteilbereichs, das durch die Zusatzinformation definiert wird, eine zulässige Toleranz des Bauteilbereichs an. Das technische Merkmal des Werkzeugteils, das durch den Code, der dem Bereich des Werkzeugteils zugeordnet wird, definiert wird, gibt eine Toleranz des Werkzeugteils an. Damit kann aus der kodierten Information zur Toleranz des Bauteilbereichs, die in dem digitalen Konstruktionsmodell des Bauteils enthalten ist, dem Werkzeugteil, das die Herstellung dieses Bauteilbereichs mitwirkt, eine kodierte Toleranz zugeordnet werden, mittels der die geforderte Toleranz des Bauteilbereichs erzielbar ist.

Gemäß einem Ausführungsbeispiel gibt das technische Merkmal des Bauteilbereichs, das durch die Zusatzinformation definiert wird, einen definierten Biegeradius oder eine zulässige Materialdehnung des Bauteilbereichs an. Das technische Merkmal des Werkzeugteils, das durch den Code, der dem Bereich des Werkzeugteils zugeordnet wird, definiert wird, gibt einen definierten Biegeradius oder eine definierte Oberflächeneigenschaft des Werkzeugteils an. Damit kann aus der kodierten Information zum Biegeradius des Bauteilbereichs, die in dem digitalen Konstruktionsmodell des Bauteils enthalten ist, dem Werkzeugteil, das die Herstellung dieses Bauteilbereichs mitwirkt, ein kodierter Biegeradius oder eine kodierte Oberflächeneigenschaft zugeordnet werden, mittels der der geforderte Biegeradius des Bauteilbereichs erzielbar ist.

Gemäß einem Ausführungsbeispiel erfolgt das zumindest
teilautomatisierte Zuordnen mittels einer Zuordnungseinheit, in der Informationen verfügbar sind, durch welches technische Merkmal des Werkzeugs das technische Merkmal des Bauteils, das durch den Code des Bauteilbereichs definiert ist, erreichbar ist. Die Informationen können entweder eine direkte Codezuordnung zwischen dem Code der Bauteil-Codierungssystematik und dem Code der Werkzeug-Codierungssystematik, insbesondere eine Farbzuordnung zwischen Farben der Bauteil-Farbkodierungssystematik und Farben der Werkzeug-Farbkodierungssystematik, aufweisen. Alternativ können die Informationen lediglich eine Zuordnung zwischen den technischen Merkmalen des Bauteils und den technischen Merkmalen des Werkzeugs schaffen und die Umsetzung der technischen Merkmale des Werkzeugs in Codes der Werkzeug-Codierungssystematik, insbesondere in Farben der Werkzeug-Farbkodierungssystematik, erfolgt mittels der Werkzeug-Codierungssystematik. Die kodierten Informationen können beispielsweise anhand einer Datenbank, einer Tabelle etc. bereitgestellt werden. Zudem kann die Zuordnungseinheit einen selbstlernenden Algorithmus aufweisen, der basierend auf rückgekoppelten Prozessdaten, wie gut ein technisches Merkmal eines Bauteils durch ein technisches Merkmal des Werkzeugs realisiert werden konnte, die Zuordnung zwischen den technischen Merkmalen des Bauteils und den technischen Merkmalen des Werkzeugs anpasst.

Gemäß einem Ausführungsbeispiel hat die Zuordnungseinheit Zugriff auf die Werkzeug-Codierungssystematik. Dabei wird durch die Zuordnungseinheit ein Code, insbesondere eine Farbe für den Bereich des Werkzeugteils ausgewählt, die dem technischen Merkmal des Werkzeugs zugeordnet ist, mittels der das geforderte technische Merkmal des Bauteilbereichs erreichbar ist. Dadurch lässt sich mittels der Zuordnungseinheit automatisiert dem Konstruktionsmodell des Werkzeugs ein technisches Merkmal hinzufügen, das nötig ist, um mit dem Werkzeug ein Bauteil herstellen zu können, das eine oder mehrere vorgegebene Anforderungen (definiert durch das technische Merkmal des Bauteilbereichs) erfüllt.

Gemäß einem Ausführungsbeispiel ist die Bauteil-Codierungssystematik eine Bauteil-Farbcodierungssystematik, die als Code Farben verwendet.

Die Verwendung von Farben als Code hat den Vorteil, dass Farbinformationen, beispielsweise als RGB-Werte über Softwareschnittstellen hinweg, beispielsweise zwischen unterschiedlichen CAD-Systemen oder zwischen einem CAD-System und einem CAM-System leicht übertragbar sind.

Gemäß einem Ausführungsbeispiel ist die Werkzeug-Codierungssystematik eine Werkzeug-Farbcodierungssystematik, die als Code Farben verwendet. Auch hier bietet die Verwendung von Farben als Code den Vorteil, dass Farbinformationen, beispielsweise als RGB-Werte über Softwareschnittstellen hinweg, beispielsweise zwischen unterschiedlichen CAD-Systemen oder zwischen einem CAD-System und einem CAM-System leicht übertragbar sind.

Gemäß einem Ausführungsbeispiel umfasst die Bauteil-Farbcodierungssystematik ein Bauteil-Farbtableau mit zumindest einer Farbleiter, die eine Startfarbe, die ein erstes Ende der Farbleiter definiert, und eine Endfarbe, die ein zweites Ende der Farbleiter definiert, aufweist. Zumindest einem Teil der zwischen der Startfarbe und der Endfarbe liegenden Zwischenfarben ist ein Satz von technischen Merkmalen zugeordnet, mittels denen technologische Eigenschaften des Bauteilbereichs definierbar sind. Damit können durch das Bauteil-Farbtableau eine Vielzahl von unterschiedlichen technischen Merkmalen des Bauteils farbkodiert dargestellt werden, beispielsweise Tabellenspalten einer Passungstabelle, Stanzgrat-Tabelle, Abmaßtabelle, etc.

Gemäß einem Ausführungsbeispiel umfasst die Werkzeug-Farbcodierungssystematik ein Werkzeug-Farbtableau mit zumindest einer Farbleiter, die eine Startfarbe, die ein erstes Ende der Farbleiter definiert, und eine Endfarbe, die ein zweites Ende der Farbleiter definiert, aufweist. Zumindest einem Teil der zwischen der Startfarbe und der Endfarbe liegenden Zwischenfarben ist ein Satz von technischen Merkmalen zugeordnet, mittels denen technologische Eigenschaften des Werkzeugs definierbar sind. Damit können durch das Werkzeug-Farbtableau eine Vielzahl von unterschiedlichen technischen Merkmalen des Werkzeugs, beispielsweise mit einer Vielzahl möglicher Steuerungs- und Informationsinhalten, farbkodiert dargestellt werden, beispielsweise Tabellenspalten einer Passungstabelle, einer Stanzgrat-Tabelle, einer Abmaßtabelle, etc.

Gemäß einem Ausführungsbeispiel sind die Startfarbe und die Endfarbe der Farbleiter durch einen numerischen Farbcode umfassend zumindest drei Farbcodewerte definiert. Die Zwischenfarben der Farbleiter werden dadurch gebildet, dass zwei Farbcodewerte, die jeweils die Startfarbe und die Endfarbe aufweisen, auch bei den Zwischenfarben konstant gehalten werden und ein dritter Farbcodewert zur Bildung unterschiedlicher Zwischenfarben variiert wird. In anderen Worten sind zumindest zwei Farbcodewerte bei allen Farben der Farbleiter gleich und die unterschiedlichen Farben der Farbleiter werden dadurch gebildet, dass ein dritter Farbcodewert verändert wird und damit die Farbcodes der unterschiedlichen Farben der Farbleiter definiert werden. Damit wird eine schrittweise Änderung der Farben entlang der Farbleiter von der Startfarbe zur Endfarbe hin erreicht, aber der Farbraum eineindeutig, systematisch und platzsparend genutzt.

Gemäß einem Ausführungsbeispiel sind die aufeinander folgenden Zwischenfarben der Farbleiter äquidistant angeordnet. Dabei weisen zwei in der Farbleiter aufeinanderfolgende Zwischenfarben jeweils den gleichen, ganzzahligen Differenzwert des dritten Farbcodewerts auf. In anderen Worten ist die Schrittweite des dritten Farbcodewerts zwischen zwei aufeinanderfolgenden Zwischenfarben gleich. Die Schrittweite kann von der Anzahl der technischen Merkmale abhängen, die durch die Farbleiter kodiert wird. Der ganzzahlige Differenzwert bzw. die Schrittweite kann eins (Ziffer 1) oder ein ganzzahliges Vielfaches von eins sein. Dadurch werden die Zwischenfarben gleichmäßig und systematisch zwischen der Startfarbe und der Endfarbe verteilt festgelegt.

Gemäß einem Ausführungsbeispiel umfasst das Bauteil-Farbtableau und/oder das Werkzeug-Farbtableau einen Satz von mehreren Farbleitern, die jeweils eine Startfarbe und eine Endfarbe aufweisen. Die Startfarbe und die Endfarbe der Farbleitern sind jeweils durch einen numerischen Farbcode umfassend zumindest drei Farbcodewerte definiert. Die Farbleitern des Satzes von Farbleitern weisen jeweils eine Startfarbe auf, bei denen zumindest zwei Farbcodewerte gleich sind und ein dritter Farbcodewert variiert wird, um die Startfarben der Farbleitern zu verändern. Der dritte Farbcodewert, mittels dem sich die Startwerte der Farbleitern voneinander unterscheiden, ist ein anderer Farbcodewert als derjenige, der zur Bildung der Zwischenfarben zwischen der Startfarbe und der Endfarbe der jeweiligen Farbleiter verwendet wird. Die dritten Farbcodewerte der aufeinander folgenden Farbleitern des Satzes von Farbleitern weisen vorzugsweise jeweils die gleiche Schrittweite bzw. den gleichen Differenzwert auf.

Gemäß einem Ausführungsbeispiel sind dem Satz von Farbleitern die Werte einer Toleranzmaßtabelle, Abmaßtabelle, Passungstabelle oder Stanzgrattabelle zugeordnet, wobei jeweils zumindest eine Spalte der Toleranzmaßtabelle, Abmaßtabelle, Passungstabelle oder Stanzgrattabelle durch eine Farbleiter des Satzes von Farbleitern abgebildet ist. Dadurch kann über den Satz von Farbleitern eine Toleranzmaßtabelle, Abmaßtabelle, Passungstabelle oder Stanzgrattabelle, zum Beispiel Tabellen gemäß dem Toleranzsystem "Einheitswelle" bzw. "Einheitsbohrung" des Tabellenbuchs Metall, Europa-Lehrmittel, ISBN: 978-3-758-51142-4, mit mehreren Tabellenabschnitten, farbkodiert werden. In analoger Weise können beliebige weitere Systematiken wie inkrementell steigende oder fallende geometrische Variation von Toleranzwerten in gleicher Weise abgebildet werden.

Gemäß einem weiteren Aspekt wird ein Computerprogramm zum Ergänzen von Informationen zu einem digitalen Konstruktionsmodell eines Werkzeugs, das zur Fertigung eines Bauteils verwendet wird, offenbart. Das Computerprogramm umfasst Befehle, die bei der Ausführung des Programms durch einen Computer diesen veranlassen, die folgenden Schritte auszuführen:
- Laden eines digitalen Konstruktionsmodells des zu fertigenden Bauteils, wobei das Bauteil zumindest einen Bauteilbereich aufweist, dem ein Code einer Bauteil-Codierungssystematik zugeordnet ist, wobei dem Bauteilbereich mittels des Codes der Bauteil-Codierungssystematik eine Zusatzinformation zugeordnet ist, die ein technisches Merkmal des Bauteilbereichs definiert, das von dem Werkzeug abhängig ist, mit dem das Bauteil gefertigt wird;
- Laden eines digitalen Konstruktionsmodells zumindest eines Werkzeugteils des Werkzeugs, das zur Fertigung des Bauteils verwendet wird;
- zumindest teilautomatisiertes Zuordnen eines Codes einer Werkzeug-Farbcodierungssystematik zu einem Bereich des digitalen Konstruktionsmodells des Werkzeugteils basierend auf der Zusatzinformation, die dem Bauteilbereich mittels dem Code der Bauteil-Codierungssystematik zugeordnet ist, wobei durch den Code der Werkzeug-Farbcodierungssystematik ein technisches Merkmal des Werkzeugteils definiert wird und wobei das Werkzeugteil und der Bauteilbereich miteinander prozesstechnologisch derart verbunden sind, dass das technische Merkmal des Bauteilbereichs durch das technische Merkmal des Bereichs des Werkzeugteils beeinflusst wird;
- zumindest teilautomatisiertes Ergänzen des Bereichs des digitalen Konstruktionsmodells des Werkzeugteils um den Code der Werkzeug-Codierungssystematik, das diesem Bereich des digitalen Konstruktionsmodells des Werkzeugteils zugeordnet wurde.

Unter "Konstruktionsmodell" im Sinne der vorliegenden Offenbarung wird ein vorzugsweise dreidimensionales, digitales Modell eines Bauteils verstanden. Ein Konstruktionsmodell kann durch ein CAD-Programm erstellt sein und definiert die geometrische Beschaffenheit des Bauteils basierend auf Nennmaßen.

Unter "Farbtableau" im Sinne der vorliegenden Offenbarung wird eine Zusammenstellung einer Vielzahl von unterschiedlichen Farben verstanden, die sich durch die Änderung der Farbwerte der Grundfarben eines Farbmodells erreichen lassen. Das Farbmodell kann beispielsweise ein RGB-Farbmodell oder ein CMYK-Farbmodell oder eine Kombination aus diesen sein.

Unter "Farbleiter" im Sinne der vorliegenden Offenbarung wird ein Satz von mehreren Farben verstanden, der eine Startfarbe, eine Endfarbe und eine Vielzahl von Zwischenfarben aufweist, die in dem Farbmodell, das dem Farbtableau zugrunde liegt, zwischen der Startfarbe und der Endfarbe liegen.

Unter "Bauteil-Codierungssystematik" wird eine Codierungssystematik, insbesondere eine Farbsystematik verstanden, mittels der eine Vielzahl von technischen Merkmalen eines Bauteils systematisch über eine Kodierung, insbesondere eine Farbkodierung darstellbar sind.

Unter "Werkzeug-Codierungssystematik" wird eine Codierungssystematik, insbesondere eine Farbsystematik verstanden, mittels der eine Vielzahl von technischen Merkmalen eines Werkzeugs systematisch über eine Kodierung, insbesondere eine Farbkodierung darstellbar sind.

Die Bauteil-Codierungssystematik und die Werkzeug-Codierungssystematik können durch eine gemeinsame Codierungssystematik oder durch zwei separate Codierungssystematiken gebildet werden.

Die Ausdrücke "näherungsweise", "im Wesentlichen" oder "etwa" bedeuten im Sinne der Erfindung Abweichungen vom jeweils exakten Wert um +/- 10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

Die Erfindung wird im Folgenden anhand mehrerer Figuren an Ausführungsbeispielen näher erläutert. Es zeigen:
- Fig. 1: beispielhaft ein Konstruktionsmodell eines Bauteils mit einem Bauteilbereich, dem über eine Kodierung ein technisches Merkmal zugeordnet ist;
- Fig. 2: beispielhaft ein Konstruktionsmodell eines Werkzeugs umfassend zwei Werkzeugteile, die zur Herstellung des Bauteils gemäß Fig.1 verwendet werden;
- Fig. 3: beispielhaft und schematisch ein Farbtableau mit mehreren Feldern, denen über einen Farbcode eindeutige Farben zugeordnet sind;
- Fig. 4: beispielhaft eine Farbleiter eines Bauteil-Farbtableaus, der Informationen einer Toleranztabelle für ein Stanzteil zugeordnet ist;
- Fig. 5: beispielhaft eine Farbleiter eines Werkzeug-Farbtableaus, der Informationen einer Tabelle für ein Passungsspiel zugeordnet ist;
- Fig. 6: beispielhaft eine Zuordnungstabelle, über die den Farben einer Farbleiter eines Bauteil-Farbtableaus die Farben einer Farbleiter eines Werkzeug-Farbtableaus zugeordnet werden können; und
- Fig. 7: ein schematisches Blockdiagramm zur Veranschaulichung der Schritte eines Verfahrens zum Ergänzen von Informationen in einem digitalen Konstriktionsmodell eines Werkzeugs.

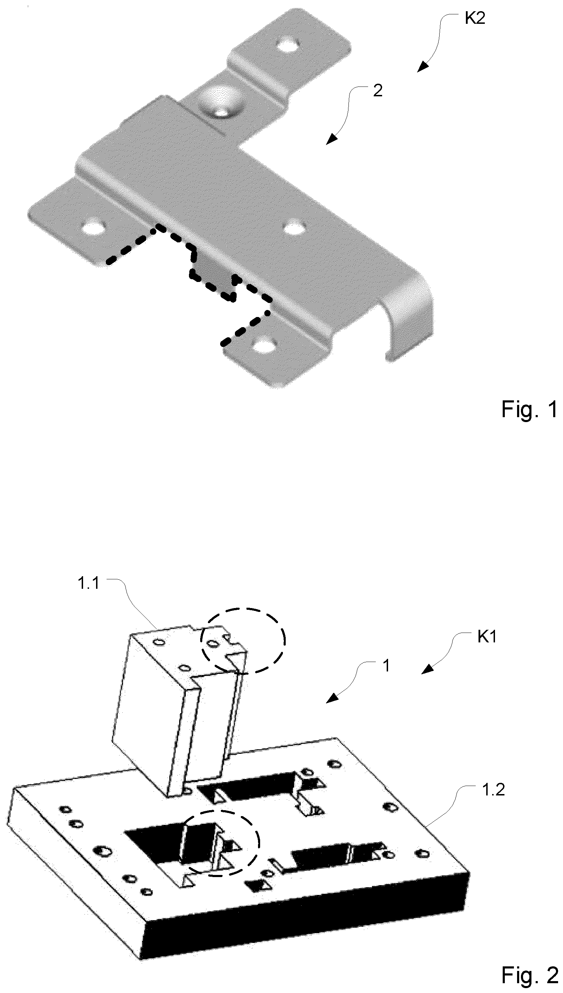

Figur 1 zeigt beispielhaft eine perspektivische Darstellung eines Konstruktionsmodells K2 eines Bauteils 2. Ein Bauteil kann einstückig gebildet oder aber aus mehreren Komponenten zusammengesetzt sein.

Das Konstruktionsmodell K2 kann beispielsweise mittels eines CAD-Programms erstellt worden sein. Ein Bauteil 2 kann mehrere Bauteilbereiche 2.1 aufweisen. Im gezeigten Ausführungsbeispiel ist das Bauteil 2 ein aus einem metallischen Flachmaterial hergestellt, beispielsweise durch Stanzen und Biegen. Es versteht sich, dass das Bauteil 2 nicht auf diese Herstellungstechniken beschränkt sein muss, sondern auch andere oder weitere Fertigungstechniken in beliebiger Kombination Verwendung finden können.

In Fig. 1 ist ein Bauteilbereich 2.1 durch die strichlierte Linie gekennzeichnet, dem ein technisches Merkmal beispielsweise in Form eines zu erreichenden maximalen Stanzgrats zugeordnet ist. Dieses technische Merkmal bildet beispielsweise eine technische Anforderung an das Bauteil 2, die bei der Herstellung des Bauteils 2 zu erreichen ist. Es versteht sich, dass das technische Merkmal auch eine andere Bauteil-Anforderung repräsentieren kann, beispielsweise eine Oberflächeneigenschaft, eine Toleranz, einen Biegeradius etc.

Dem Bauteilbereich 2.1 ist ein Code, insbesondere eine Farbe zugeordnet, über den/die das technische Merkmal definiert wird, das der Bauteilbereich 2.1 zu erfüllen hat. Beispielsweise kann der Bauteilbereich 2.1 mit dieser Farbe eingefärbt sein. Der Bauteilbereich 2.1 kann beispielsweise ein flächiger Bereich des Bauteils, eine Kante, eine Bohrung, eine Öffnung etc. sein.

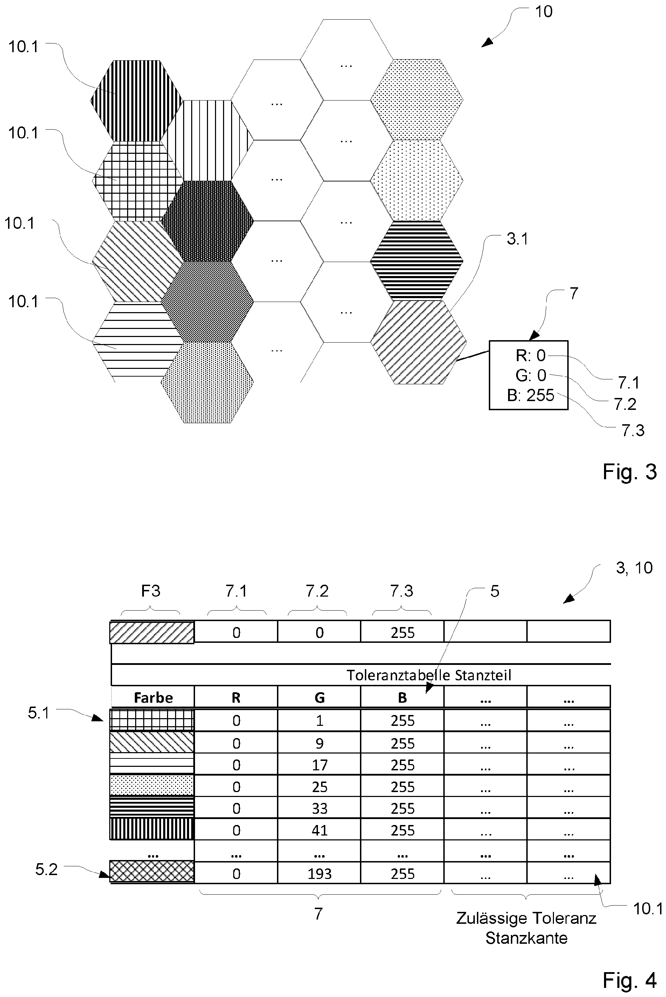

Die Zuordnung, welches technische Merkmal durch den jeweiligen Code, insbesondere durch die jeweilige Farbe repräsentiert wird, erfolgt über eine Bauteil-Codierungssystematik 3, insbesondere eine Bauteil-Farbcodierungssystematik 3. Die Bauteil-Farbcodierungssystematik 3 umfasst zumindest ein Bauteil-Farbtableau 10, das nachfolgend im Zusammenhang mit Fig. 4 näher beschrieben wird.

Fig. 2 zeigt ein Konstruktionsmodell K1 eines Werkzeugs 1, das zur Herstellung des Bauteils 2 gemäß Fig. 1 Verwendung findet. Das Werkzeug 1 ist beispielsweise ein Stanzwerkzeug. Es umfasst einen ersten Werkzeugteil 1.1 und einen zweiten Werkzeugteil 1.2. Das Werkzeug 2 ist dazu ausgebildet, durch Relativbewegung zueinander ein metallisches Flachmaterial zu stanzen und dabei die in Fig. 1 durch die gestrichelte Linie hervorgehobene Kante des Bauteils 2 zu erzeugen. Dabei beeinflussen die in Fig. 2 durch die gestrichelt gezeichneten Ovale gekennzeichneten Bereiche des Werkzeugs 1 die technischen Eigenschaften der Kante des Bauteils 2, die in Fig. 1 durch die gestrichelte Linie hervorgehoben ist. In anderen Worten besteht zwischen der technischen Anforderung, die an die Kante des Bauteils 2 gestellt wird und den technischen Eigenschaften, die die durch die gestrichelt gezeichneten Ovale gekennzeichneten Bereiche des Werkzeugs 1 aufweisen, ein unmittelbarer kausaler Zusammenhang.

So ist beispielsweise der Stanzgrat, der an der Kante des Bauteils 2 entsteht, unmittelbar davon abhängig, welches Passungsspiel zwischen dem ersten und zweiten Werkzeugteil 1.1, 1.2 besteht.

Nachfolgend wird erläutert, auf welche Weise in zumindest teilautomatisierter Weise ein Konstruktionsmodell K1 eines Werkzeugs 1 basierend auf einem Konstruktionsmodell K2 des Bauteils 2, das mittels des Werkzeugs 1 hergestellt wird, um Informationen ergänzt werden kann, damit das Bauteil 2, das mit dem Werkzeug 1 gefertigt wird, die geforderte Spezifikationen erfüllt.

Fig. 3 zeigt beispielhaft einen Auszug aus einem Bauteil-Farbtableau 10, wobei aus Darstellungsgründen die Farbfelder durch unterschiedliche Schraffuren ersetzt wurden. Es versteht sich, dass jeweils eine Schraffur eine bestimmte Farbe darstellen soll.

Das Bauteil-Farbtableau 10 fußt auf einem Farbmodell, beispielsweise dem RGB-Farbmodell oder dem CMY/CMYK-Farbmodell. Es umfasst eine Vielzahl von Feldern 10.1, wobei die Felder 10.1 jeweils unterschiedliche Farben aufweisen. Die Farben der Felder 10.1 sind jeweils durch einen Farbcode 7 eindeutig festgelegt, wobei der Farbcode 7 die Farbe basierend auf den Farbbestandteilen oder Grundfarben des jeweiligen Farbmodells definiert. In dem RGB-Farbmodell kann eine Farbe beispielsweise durch drei Farbcodewerte 7.1, 7.2, 7.3 definiert werden, die die Anteile der Grundfarben Rot (R), Grün (G), und Blau (B) in der jeweiligen Farbe repräsentieren. Das Bauteil-Farbtableau 10 kann einen Teil des Farbraums des jeweiligen Farbmodells oder den gesamten Farbraum überspannen.

Den Feldern 10.1 des Bauteil-Farbtableaus 10 ist zumindest teilweise jeweils eine spezifische Zusatzinformation zugeordnet, die ein spezifisches technisches Merkmal eines Bauteilbereichs 2.1 repräsentiert. In anderen Worten ist aufgrund der Zuordnung der Zusatzinformation zu dem jeweiligen Feld 10.1 des Farbtableaus 10 die diesem Feld 10.1 zugeordnete Farbe mit einer Information belegt, welches technisches Merkmal ein Bauteilbereich 2.1 aufweisen soll, der mit der Farbe dieses Felds 10.1 eingefärbt ist. Einige Beispiele für technische Merkmale des Bauteils 2 sind: Ausprägung des Stanzgrats, Oberflächeneigenschaft, geometrische Toleranz, Biegeradius etc.

Das Bauteil-Farbtableau 10 bietet den technischen Vorteil, dass durch die Zuordnung einer Farbe des Bauteil-Farbtableaus 10 zu einem Bauteilbereich 2.1 eines Bauteils 2 diesem Bauteil 2 zudem ein technisches Merkmal zugeordnet wird, das aus dem Konstruktionsmodell K2 des Bauteils 2 maschinell auslesbar ist. Die Verwendung einer Farbe als Informationsträger hat den Vorteil, dass eine Informationsübertragung auch bei heterogenen Systemen (beispielsweise zwischen CAD und CAM) möglich ist, da bei heterogenen Systemen die Farben eindeutig übergeben werden und damit die Information zur geometrischen Toleranz entlang der Prozesskette systemunabhängig ausgelesen werden kann.

Fig. 4 zeigt einen Auszug aus einem beispielhaften Bauteil-Farbtableau 10 einer Bauteil-Farbkodierungssystematik 3 in tabellarischer Form, bei dem den Feldern des Bauteil-Farbtableaus 10 beispielhaft als technische Merkmale geometrische Toleranzinformationen zugeordnet sind. Das gezeigte Bauteil-Farbtableau 10 bildet beispielsweise die geometrischen Toleranzinformationen für Stanzteile über die entsprechenden Farben des Farbtableaus ab. Der Auszug des Bauteil-Farbtableaus 10 bildet eine Farbleiter 5, die einer Farbcodierungssystematik folgt. Die Farbleiter 5 weist eine Startfarbe 5.1 und eine Endfarbe 5.2 auf. Die Startfarbe 5.1 und die Endfarbe 5.2 sind durch die Farbcodewerte 7.1, 7.2, 7.3 gemäß der gewählten Farbcodierung vorgegeben. Das beschriebene Beispiel nutzt das RGB-Farbmodell, so dass ein Farbcode durch folgendes Schema vorgegeben ist:
(R:xxx; G:yyy; B:zzz), wobei xxx für den Rotanteil, yyy für den Grünanteil und zzz für den Blauanteil der jeweiligen Farbe steht.

Die Farbleiter 5 der Fig. 4 zeigt ein Bauteil-Farbtableau 10, mittels der beispielhaft Informationen zur zulässigen Toleranz eines Stanzteils mittels Farben einer Farbleiter kodiert werden. Die Farbleiter weist beispielsweise "blau" als Startfarbe 4.1 auf, wobei diese durch den Farbcode 7 mit den Farbcodewerten 7.1, 7.2, 7.3 "0", "0" und "255" festgelegt ist. Die Endfarbe 5.2 der Farbleiter 5 wird durch den Farbcode 7 mit den Farbcodewerten 7.1, 7.2, 7.3 "0", "193" und "255" festgelegt. Es versteht sich, dass die Farbleiter 5 länger oder kürzer sein kann, um diese an die jeweilige Menge an abzubildenden Toleranzinformationen anzupassen.

Die linke Spalte der Tabelle gemäß Fig. 4 verdeutlicht die Farbe F3 (nachgebildet durch unterschiedliche Schraffuren), die zweite bis vierte Spalte (von links) die Farbcodewerte 7.1, 7.2, 7.3 des Farbcodes 7. In der fünften und sechsten Spalte sind der jeweiligen Farbe F3 beispielhaft Toleranzinformationen für Stanzteile zugeordnet, wie diese beispielhaft in dem Tabellenbuch Metall, Europa-Lehrmittel, ISBN: 978-3-758-51142-4 zu finden sind.

Die Farbleiter 5 weist zwischen der Startfarbe 5.1 und der Endfarbe 5.2 eine Vielzahl von Zwischenfarben auf. Vorzugsweise werden gemäß der verwendeten Farbcodierungssystematik die Zwischenfarben der Farbleiter 5 dadurch erhalten, dass zwei Farbcodewerte 7.1, 7.3 konstant gehalten werden und ein dritter Farbcodewert 7.2 (Grün-Wert) schrittweise erhöht wird. Das Erhöhen des dritten Farbcodewerts 7.2 erfolgt vorzugsweise mit einer diskreten Schrittweite. Im gezeigten Ausführungsbeispiel beträgt die Schrittweite 8, kann aber auch abweichend davon größer oder kleiner gewählt sein, beispielsweise Schrittweite 1. Da die Farbe F3 mit dessen Farbcode 7 eindeutig ist, kann diese schnittstellenunabhängig zur Weitergabe einer Vielzahl von Informationen genutzt werden, wobei die Informationen durch das Bauteil-Farbtableau 10, die beispielsweise als look-up-Tabelle fungiert, zur Verfügung gestellt werden.

Wird das Konstruktionsmodell 1 nun von einem CAM-System zur Herstellung des Bauteils verwendet, kann über die dem Bauteilbereich 2.1 zugeordneten Farbe F3 und das Bauteil-Farbtableau 10 automatisiert das technische Merkmal ausgelesen werden, das der Bauteilbereich 2.1 zu erfüllen hat. Diese Information kann bei der Steuerung Bearbeitungsmaschine selbst und/oder bei einem nachgelagerten Prüfprozess verwendet werden.

Häufig wird ein Bauteil 2 maschinell gefertigt, wobei bei der Herstellung ein Werkzeug 1 verwendet wird, das selbst speziell für die Herstellung des Bauteils 2 konstruiert wurde. Ein Beispiel ist ein Werkzeug 1, das für einen Stanzprozess oder einen Umformprozess verwendet wird.

Zwischen dem Werkzeug 1 und dem damit herzustellenden Bauteil 2 besteht ein fertigungstechnologischer Zusammenhang, und zwar derart, dass das Werkzeug 1 zumindest ein technisches Merkmal erfüllen muss, damit ein Bauteilbereich des Bauteils 2 geforderte Spezifikationen erfüllt, die über ein oder mehrere technische Merkmale definiert sind, die im digitalen Konstruktionsmodell des Bauteils 2 mittels einer oder mehrerer Farben des Bauteil-Farbtableaus 10 repräsentiert sind. Ein Beispiel hierfür ist, dass ein als technische Spezifikation vorgegebener Stanzgrat an einer Kante des Bauteils 2 aus einem Passungsspiel des Stanzwerkzeugs resultiert, d.h. aus dem in digitalen Konstruktionsmodell K2 des Bauteils 2 enthaltenen technischen Merkmal "Ausprägung des Stanzgrats" lässt sich ein Passungsspiel des Stanzwerkzeugs in dem Werkzeugbereich ableiten, mittels denen die jeweilige Kante des Bauteils 2 gestanzt wird.

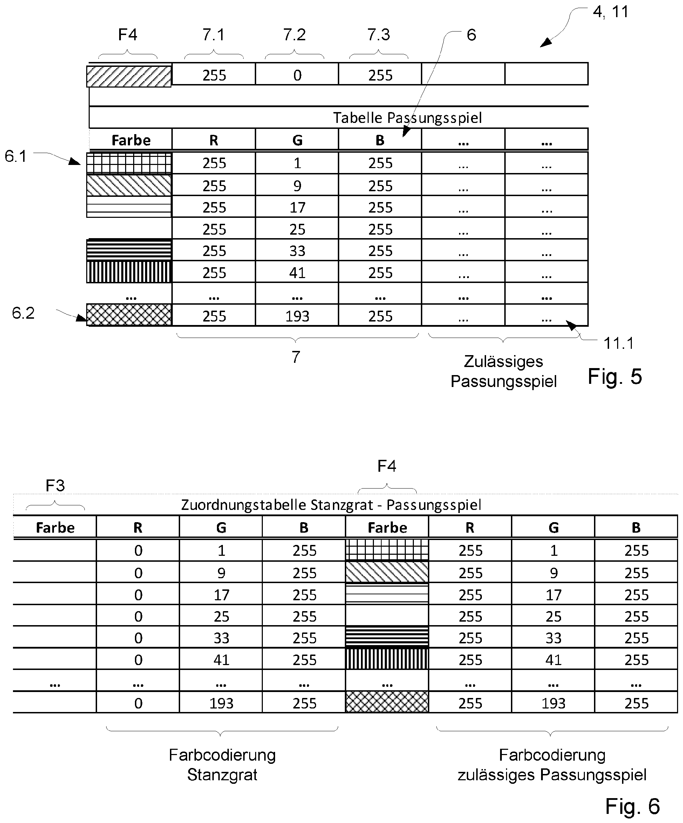

Fig. 5 zeigt beispielhaft eine Farbleiter 6 einer Werkzeug-Farbcodierungssystematik 4, mittels der technische Merkmale farbcodiert in einem Konstruktionsmodell K1 eines Werkzeugs 1 darstellbar sind.

Mittels der Farbleiter 6 werden Farben F4 einer Werkzeug-Farbcodierungssystematik 4 technische Merkmale zugeordnet, die ein oder mehrere Werkzeugteile charakterisieren können. Beispielsweise wird über die Farbleiter 6, die in Fig. 5 gezeigt ist, den Farben F4 jeweils Informationen zu einem zulässigen Passungsspiel zugeordnet. Damit kann über die Farben F4 beispielsweise das in Fig. 2 gezeigte Konstruktionsmodell K1 der Werkzeugteile 1.1, 1.2 eines Stanzwerkzeugs um eine Information ergänzt werden, welches Passungsspiel der Schneidstempel relativ zur Schneidplatte haben darf.

Der Aufbau der Werkzeug-Farbcodierungssystematik 4 ist vorzugsweise gleich oder im Wesentlichen gleich zu der Bauteil-Farbcodierungssystematik 3, die vorstehend anhand der Fig. 4 erläutert wurde.

Der Auszug der Werkzeug-Farbcodierungssystematik 4 bildet ein Werkzeug-Farbtableau 11 mit einer Farbleiter 6, die einer Farbcodierungssystematik folgt. Die Farbleiter 6 weist eine Startfarbe 6.1 und eine Endfarbe 6.2 auf. Die Startfarbe 6.1 und die Endfarbe 6.2 sind durch die Farbcodewerte 7.1, 7.2, 7.3 gemäß der gewählten Farbcodierung vorgegeben. Das beschriebene Beispiel nutzt das RGB-Farbmodell, so dass ein Farbcode durch folgendes Schema vorgegeben ist: (R:xxx; G:yyy; B:zzz), wobei xxx für den Rotanteil, yyy für den Grünanteil und zzz für den Blauanteil der jeweiligen Farbe steht.

Die Farbleiter 6 der Fig. 5 zeigt ein Werkzeug-Farbtableau 11, mittels dem beispielhaft Informationen zum zulässigen Passungsspiels eines Werkzeugs 1 mittels Farben einer Farbleiter kodiert werden. Die Farbleiter 6 weist beispielsweise "Magenta" als Startfarbe auf, wobei diese durch den Farbcode 7 mit den Farbcodewerten 7.1, 7.2, 7.3 "255", "0" und "255" festgelegt ist. Die Endfarbe 6.2 der Farbleiter 6 wird durch den Farbcode 7 mit den Farbcodewerten 7.1, 7.2, 7.3 "255", "193" und "255" festgelegt. Es versteht sich, dass die Farbleiter 6 länger oder kürzer sein kann, um diese an die jeweilige Menge an abzubildenden Passungsspiel-Informationen anzupassen.

Die linke Spalte der Tabelle gemäß Fig. 5 verdeutlicht die Farbe F4 (nachgebildet durch unterschiedliche Schraffuren), die zweite bis vierte Spalte (von links) die Farbcodewerte 7.1, 7.2, 7.3 des Farbcodes 7. In der fünften und sechsten Spalte sind der jeweiligen Farbe F4 beispielhaft Passungsspiel-Informationen für Stanzteile zugeordnet, wie diese beispielhaft in dem Tabellenbuch Metall, Europa-Lehrmittel, ISBN: 978-3-758-51142-4 zu finden sind.

Die Farbleiter 6 weist zwischen der Startfarbe 6.1 und der Endfarbe 6.2 eine Vielzahl von Zwischenfarben auf. Vorzugsweise werden gemäß der verwendeten Werkzeug-Farbcodierungssystematik die Zwischenfarben der Farbleiter 6 dadurch erhalten, dass zwei Farbcodewerte 7.1, 7.3 konstant gehalten werden und ein dritter Farbcodewert 7.2 (Grün-Wert) schrittweise erhöht wird. Das Erhöhen des dritten Farbcodewerts 7.2 erfolgt vorzugsweise mit einer diskreten Schrittweite. Im gezeigten Ausführungsbeispiel beträgt die Schrittweite 8, kann aber auch abweichend davon größer oder kleiner gewählt sein, beispielsweise Schrittweite 1. Da die Farbe F4 mit dessen Farbcode 7 eindeutig ist, kann diese schnittstellenunabhängig zur Weitergabe einer Vielzahl von Informationen genutzt werden, wobei die Informationen durch das Werkzeug-Farbtableau 11, die beispielsweise als look-up-Tabelle fungiert, zur Verfügung gestellt werden.

Fig. 6 zeigt beispielhaft eine Zuordnungstabelle Z, über die durch eine Zuordnungseinheit eine Farbe F3 der Bauteil-Farbcodierungssystematik 3 einer Farbe F4 der Bauteil-Farbcodierungssystematik 4 zugeordnet werden kann. Die Zuordnungseinheit kann beispielsweise eine zumindest teilweise softwareimplementierte Funktionseinheit einer Rechnereinheit sein.

Mittels der Zuordnungstabelle Z kann eine Farbe F3, die im digitalen Konstruktionsmodell K2 des Bauteils 2 zur Angabe des zulässigen Stanzgrats verwendet wird, einer Farbe F4 zugeordnet werden, die im Konstruktionsmodell K1 des Werkzeugs 1 zu verwenden ist, um über diese Farbe F4 dort zu definieren, welches Passungsspiel im Werkzeug 1 zulässig ist, um beim Einsatz dieses Werkzeugs 1 zur Fertigung des Bauteils 2 ein Bauteil zu erhalten, das den zulässigen Stanzgrat aufweist. In anderen Worten enthält die Zuordnungstabelle Z über die Zuordnung der Farben F3, F4 Technologieinformationen und die Zuordnungstabelle Z ermöglicht eine Transformation von Farben der Bauteil-Farbcodierungssystematik 3 in Farben der Bauteil-Farbcodierungssystematik 4. Da Farben in digitalen Konstruktionsmodellen eindeutig und schnittstellenübergreifend übertragbar sind, beispielsweise zwischen CAD und CAM, lassen sich durch das vorgeschlagene Verfahren zumindest teilautomatisch Zusatzinformationen in dem digitalen Konstruktionsmodell K1 des Werkzeugs 1 ergänzen, die bei dem Herstellungsprozess und ggf. auch bei einem nachfolgenden Mess- und Prüfprozess vorteilhaft sind.

Es versteht sich, dass die Zuordnungen der Zuordnungstabelle Z rein beispielhaft sind und mittels einer derartigen Zuordnungstabelle Z beliebige Informationen von Bauteil 2 und Werkzeug 1 miteinander verknüpft werden können, die einen technologischen Zusammenhang zueinander haben. Auch ist es möglich, dass über eine Zuordnungstabelle Z eine Mehrfachzuordnung von Informationen erfolgt, insbesondere dann wenn eine Anforderung eines Bauteils 2 von mehreren Merkmalen des Werkzeugs 1 abhängt.

Im Unterschied zu der in Fig. 6 gezeigten Zuordnungstabelle Z kann eine alternative Zuordnungstabelle lediglich technische Merkmale eines Bauteils 2 einem oder mehreren technischen Merkmalen eines Werkzeugs 1 zuordnen. Die Zuordnung des jeweiligen technischen Merkmals des Werkzeugs 1 zu einer Farbe des Werkzeug-Farbtableaus 11 kann anschließend über die Werkzeug-Farbkodierungssystematik 4 erfolgen.

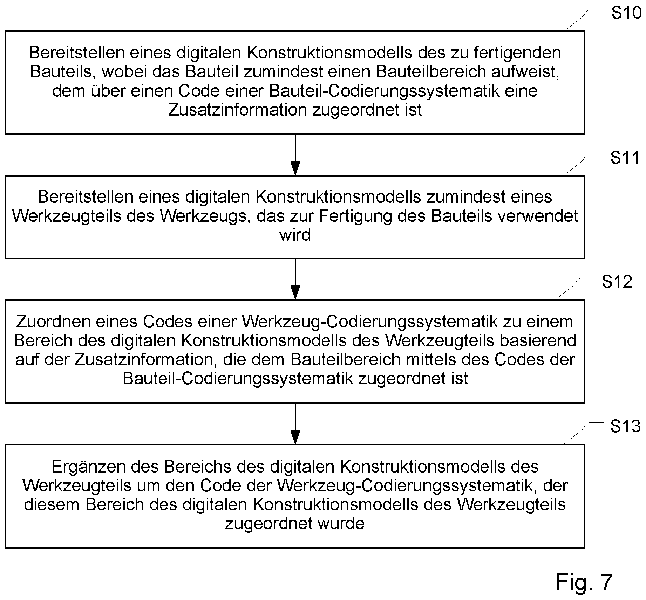

Fig. 7 zeigt ein Blockdiagramm, das die Schritte des Verfahrens zum Ergänzen von Informationen in einem digitalen Konstruktionsmodell eines Werkzeugs verdeutlicht.

Zunächst wird ein digitales Konstruktionsmodell des zu fertigenden Bauteils bereitgestellt. Das Bauteil weist zumindest einen Bauteilbereich auf, dem ein Code einer Bauteil-Codierungssystematik zugeordnet ist. Dem Bauteilbereich ist mittels des Codes der Bauteil-Codierungssystematik eine Zusatzinformation zugeordnet, die ein technisches Merkmal des Bauteilbereichs definiert, die von dem Werkzeug abhängig ist, mit dem das Bauteil gefertigt wird (S10). Die Zusatzinformation kann insbesondere eine technische Anforderung angeben, die das Bauteil zu erfüllen hat.

Zudem wird ein digitales Konstruktionsmodells zumindest eines Werkzeugteils des Werkzeugs bereitgestellt, das zur Fertigung des Bauteils verwendet wird (S11). Das Werkzeug kann insbesondere ein auf das Bauteil spezifisch angepasstes Herstellungswerkzeug sein. Beispiele für derartige Werkzeuge sind Stanzwerkzeuge, Umformwerkzeuge, Urformwerkzeuge wie z.B. Kunststoff-Spritzgusswerkzeuge, Leichtmetall-Druckgusswerkzeuge oder Werkzeuge für Schmiedeprozesse etc.

Anschließend wird zumindest teilautomatisiert ein Code einer Werkzeug-Codierungssystematik einem Bereich des digitalen Konstruktionsmodells des Werkzeugteils zugeordnet, und zwar basierend auf der Zusatzinformation, die dem Bauteilbereich mittels des Codes der Bauteil-Codierungssystematik zugeordnet ist (S12). Durch den Code der Werkzeug-Codierungssystematik wird ein technisches Merkmal des Werkzeugteils definiert. Das Werkzeugteil und der Bauteilbereich sind prozesstechnologisch derart miteinander verbunden, dass das technische Merkmal des Bauteilbereichs durch das technische Merkmal des Bereichs des Werkzeugteils beeinflusst wird. In anderen Worten wirkt sich beim Herstellungsprozess der Bereich des Werkzeugteils auf den Bauteilbereich aus.

Zuletzt wird zumindest teilautomatisiert der Bereich des digitalen Konstruktionsmodells des Werkzeugteils um den Code der Werkzeug-Codierungssystematik, das diesem Bereich des digitalen Konstruktionsmodells des Werkzeugteils zugeordnet wurde, ergänzt (S13). Nach dem Ergänzen des digitalen Konstruktionsmodells des Werkzeugteils kann beispielsweise ein Abspeichern des ergänzten Konstruktionsmodells erfolgen.

Die Erfindung wurde voranstehend an Ausführungsbeispielen beschrieben. Es versteht sich, dass zahlreiche Änderungen sowie Abwandlungen möglich sind, ohne dass dadurch der durch die Patentansprüche definierte Schutzbereich verlassen wird.

### Bezugszeichenliste

- 1: Werkzeug
- 1.1: erstes Werkzeugteil
- 1.2: zweites Werkzeugteil
- 2: Bauteil
- 2.1: Bauteilbereich
- 3: Bauteil-Codierungssystematik
- 4: Werkzeug-Codierungssystematik
- 5: Farbleiter
- 5.1: Startfarbe
- 5.2: Endfarbe
- 6: Farbleiter
- 6.1: Startfarbe
- 6.2: Endfarbe
- 7: Farbcode
- 7.1: erster Farbcodewert
- 7.2: zweiter Farbcodewert
- 7.3: dritter Farbcodewert

- 10: Bauteil-Farbtableau
- 10.1: Feld
- 11: Werkzeug-Farbtableau

- K1: Konstruktionsmodell des Werkzeugs
- K2: Konstruktionsmodell des Bauteils
- F3: Code der Bauteil-Farbkodierungssystematik
- F4: Code der Werkzeug-Farbkodierungssystematik
- Z: Zuordnungstabelle

## Patentansprüche

1. Computerimplementiertes Verfahren zum Ergänzen von Informationen in einem digitalen Konstruktionsmodell eines Werkzeugs (1), das zur Fertigung eines Bauteils (2) verwendet wird, wobei das Verfahren folgende Schritte umfasst:
- Bereitstellen eines digitalen Konstruktionsmodells (K2) des zu fertigenden Bauteils (2), wobei das Bauteil (2) zumindest einen Bauteilbereich (2.1) aufweist, dem Code (F3) einer Bauteil-Codierungssystematik (3) zugeordnet ist, wobei dem Bauteilbereich (2.1) mittels dem Code (F3) der Bauteil-Codierungssystematik (3) eine Zusatzinformation zugeordnet ist, die ein technisches Merkmal des Bauteilbereichs (2.1) definiert, das von dem Werkzeug (1) abhängig ist, mit dem das Bauteil (2) gefertigt wird (S10);
- Bereitstellen eines digitalen Konstruktionsmodells (K1) zumindest eines Werkzeugteils (1.1, 1.2) des Werkzeugs (1), das zur Fertigung des Bauteils (2) verwendet wird (S11);
- zumindest teilautomatisiertes Zuordnen eines Codes (F4) einer Werkzeug-Codierungssystematik (4) zu einem Bereich des digitalen Konstruktionsmodells (K1) des Werkzeugteils basierend auf der Zusatzinformation, die dem Bauteilbereich (2.1) mittels des Codes (F3) der Bauteil-Codierungssystematik (3) zugeordnet ist, wobei durch den Code (F4) der Werkzeug-Codierungssystematik (4) ein technisches Merkmal des Werkzeugteils (1.1, 1.2) definiert wird und wobei das Werkzeugteil (1.1, 1.2) und der Bauteilbereich (2.1) miteinander prozesstechnologisch derart verbunden sind, dass das technische Merkmal des Bauteilbereichs (2.1) durch das technische Merkmal des Bereichs des Werkzeugteils (1.1, 1.2) beeinflusst wird (S12);
- zumindest teilautomatisiertes Ergänzen des Bereichs des digitalen Konstruktionsmodells (K1) des Werkzeugteils um den Code (F4) der Werkzeug-Codierungssystematik (4), der diesem Bereich des digitalen Konstruktionsmodells (K1) des Werkzeugteils (1.1, 1.2) zugeordnet wurde (S13).

2. Verfahren nach Anspruch 1, **dadurch gekennzeichnet, dass** das technische Merkmal des Bauteilbereichs (2.1), das durch die Zusatzinformation definiert wird, einen definierten Stanzgrat angibt und dass das technische Merkmal des Werkzeugteils (1.1, 1.2), das durch den Code, der dem Bereich des Werkzeugteils (1.1, 1.2) zugeordnet wird, definiert wird, ein definiertes Passungsspiel des Werkzeugs (1) angibt.

3. Verfahren nach Anspruch 1 oder 2, **dadurch gekennzeichnet, dass** das technische Merkmal des Bauteilbereichs (2.1), das durch die Zusatzinformation definiert wird, eine definierte Oberflächeneigenschaft des Bauteilbereichs (2.1) angibt und dass das technische Merkmal des Werkzeugteils (1.1, 1.2), das durch den Code, der dem Bereich des Werkzeugteils (1.1, 1.2) zugeordnet wird, definiert wird, eine definierte Oberflächeneigenschaft des Werkzeugteils (1.1, 1.2) angibt.

4. Verfahren nach einem der vorhergehenden Ansprüche, **dadurch gekennzeichnet, dass** das technische Merkmal des Bauteilbereichs (2.1), das durch die Zusatzinformation definiert wird, eine definierte zulässige Toleranz des Bauteilbereichs (2.1) angibt und dass das technische Merkmal des Werkzeugteils (1.1, 1.2), das durch den Code, der dem Bereich des Werkzeugteils (1.1, 1.2) zugeordnet wird, definiert wird, eine definierte zulässige Toleranz des Werkzeugteils (1.1, 1.2) angibt.

5. Verfahren nach einem der vorhergehenden Ansprüche, **dadurch gekennzeichnet, dass** das technische Merkmal des Bauteilbereichs (2.1), das durch die Zusatzinformation definiert wird, einen Biegeradius oder eine zulässige Materialdehnung des Bauteilbereichs (2.1) angibt und dass das technische Merkmal des Werkzeugteils (1.1, 1.2), das durch den Code, der dem Bereich des Werkzeugteils (1.1, 1.2) zugeordnet wird, definiert wird, einen Biegeradius und/oder eine Oberflächeneigenschaft des Werkzeugteils (1.1, 1.2) angibt.

6. Verfahren nach einem der vorhergehenden Ansprüche, **dadurch gekennzeichnet, dass** das zumindest teilautomatisierte Zuordnen mittels einer Zuordnungseinheit erfolgt, in der Informationen verfügbar sind, durch welches technische Merkmal des Werkzeugs (1) das technische Merkmal des Bauteils (2), das durch den Code des Bauteilbereichs (2.1) definiert ist, erreichbar ist.

7. Verfahren nach Anspruch 6, **dadurch gekennzeichnet, dass** die Zuordnungseinheit Zugriff auf die Werkzeug-Codierungssystematik (4) hat und einen Code für den Bereich des Werkzeugteils (1.1, 1.2) auswählt, die dem technischen Merkmal des Werkzeugs (1) zugeordnet ist, mittels der das geforderte technische Merkmal des Bauteilbereichs (2.1) erreichbar ist.

8. Verfahren nach einem der vorhergehenden Ansprüche, **dadurch gekennzeichnet, dass** die Bauteil-Codierungssystematik (3) eine Bauteil-Farbcodierungssystematik ist, die als Code Farben verwendet und/oder dass die Werkzeug-Codierungssystematik (4) eine Werkzeug-Farbcodierungssystematik ist, die als Code Farben verwendet.

9. Verfahren nach Anspruch 8, **dadurch gekennzeichnet, dass** die Bauteil-Farbcodierungssystematik (3) ein Bauteil-Farbtableau mit zumindest einer Farbleiter (5) umfasst, die eine Startfarbe (5.1), die ein erstes Ende der Farbleiter (5) definiert, und eine Endfarbe (5.2), die ein zweites Ende der Farbleiter (5) definiert, aufweist, wobei zumindest einem Teil der zwischen der Startfarbe (5.1) und der Endfarbe (5.2) liegenden Zwischenfarben ein Satz von technischen Merkmalen zugeordnet sind, mittels denen technologische Eigenschaften des Bauteilbereichs (2.1) definierbar sind.

10. Verfahren nach einem der Ansprüche 8 oder 9, **dadurch gekennzeichnet, dass** die Werkzeug-Farbcodierungssystematik (F4) ein Werkzeug-Farbtableau mit zumindest einer Farbleiter (6) umfasst, die eine Startfarbe (6.1), die ein erstes Ende der Farbleiter (6) definiert, und eine Endfarbe (6.2), die ein zweites Ende der Farbleiter (6) definiert, aufweist, wobei zumindest einem Teil der zwischen der Startfarbe (6.1) und der Endfarbe (6.2) liegenden Zwischenfarben ein Satz von technischen Merkmalen zugeordnet sind, mittels denen technologische Eigenschaften des Werkzeugs (1) definierbar sind.

11. Verfahren nach Anspruch 9 oder 10, **dadurch gekennzeichnet, dass** die Startfarbe (5.1, 6.1) und die Endfarbe (5.2, 6.2) der Farbleiter (5, 6) durch einen numerischen Farbcode (7) umfassend zumindest drei Farbcodewerte (7.1, 7.2, 7.3) definiert sind und die Zwischenfarben der Farbleiter (5, 6) dadurch gebildet werden, dass zwei Farbcodewerte (7.1, 7.2), die jeweils die Startfarbe (5.1, 6.1) und die Endfarbe (5.2, 6.2) aufweisen, auch bei den Zwischenfarben konstant gehalten werden und ein dritter Farbcodewert (7.3) zur Bildung unterschiedlicher Zwischenfarben variiert wird.

12. Verfahren nach Anspruch 11, **dadurch gekennzeichnet, dass** die aufeinander folgenden Zwischenfarben der Farbleiter (5, 6) äquidistant angeordnet sind, wobei jeweils zwei in der Farbleiter (5, 6) aufeinanderfolgende Zwischenfarben jeweils den gleichen, ganzzahligen Differenzwert des dritten Farbcodewerts (7.3) aufweisen.

13. Verfahren nach einem der Ansprüche 9 bis 12, **dadurch gekennzeichnet, dass** das Bauteil-Farbtableau und/oder das Werkzeug-Farbtableau einen Satz von mehreren Farbleitern (5, 6) umfasst, die jeweils eine Startfarbe (5.1, 6.1) und eine Endfarbe (5.2, 6.2) aufweisen, wobei die Startfarbe (5.1) und die Endfarbe (5.2) der Farbleiter (5) durch einen numerischen Farbcode (7) umfassend zumindest drei Farbcodewerte (7.1, 7.2, 7.3) definiert sind und dass die Farbleitern (5, 6) des Satzes von Farbleitern jeweils eine Startfarbe (5.1, 6.1) aufweisen, bei denen zumindest zwei Farbcodewerte (7.1, 7.3) gleich sind und ein dritter Farbcodewert (7.2) variiert wird, um die Startfarben (5.1, 6.1) der Farbleitern (5, 6) zu verändern.

14. Verfahren nach Anspruch 13, **dadurch gekennzeichnet, dass** dem Satz von Farbleitern (5, 6) die Werte einer Toleranzmaßtabelle, Abmaßtabelle und/oder Passungstabelle zugeordnet sind, wobei jeweils zumindest eine Spalte der Toleranzmaßtabelle, Abmaßtabelle und/oder Passsungstabelle durch eine Farbleiter (5, 6) des Satzes von Farbleitern (5, 6) abgebildet ist.

15. Computerprogramm zum Ergänzen von Informationen zu einem digitalen Konstruktionsmodell (K1) eines Werkzeugs (1), das zur Fertigung eines Bauteils (2) verwendet wird, umfassend Befehle, die bei der Ausführung des Programms durch einen Computer diesen veranlassen, die folgenden Schritte auszuführen:
- Laden eines digitalen Konstruktionsmodells (K2) des zu fertigenden Bauteils (2), wobei das Bauteil (2) zumindest einen Bauteilbereich (2.1) aufweist, dem ein Code (F3) einer Bauteil-Codierungssystematik (3) zugeordnet ist, wobei dem Bauteilbereich (2.1) mittels dem Code (F3) der Bauteil-Codierungssystematik (3) eine Zusatzinformation zugeordnet ist, die ein technisches Merkmal des Bauteilbereichs (2.1) definiert, das von dem Werkzeug (1) abhängig ist, mit dem das Bauteil (2) gefertigt wird;
- Laden eines digitalen Konstruktionsmodells (K1) zumindest eines Werkzeugteils (1.1, 1.2) des Werkzeugs (1), das zur Fertigung des Bauteils (2) verwendet wird;
- zumindest teilautomatisiertes Zuordnen eines Codes (F4) einer Werkzeug-Codierungssystematik (4) zu einem Bereich des digitalen Konstruktionsmodells (K1) des Werkzeugteils (1.1, 1.2) basierend auf der Zusatzinformation, die dem Bauteilbereich (2.1) mittels des Codes (F3) der Bauteil-Codierungssystematik (3) zugeordnet ist, wobei durch den Code (F4) der Werkzeug-Codierungssystematik (4) ein technisches Merkmal des Werkzeugteils (1.1, 1.2) definiert wird und wobei das Werkzeugteil (1.1, 1.2) und der Bauteilbereich (2.1) miteinander prozesstechnologisch derart verbunden sind, dass das technische Merkmal des Bauteilbereichs (2.1) durch das technische Merkmal des Bereichs des Werkzeugteils (1.1, 1.2) beeinflusst wird;
- zumindest teilautomatisiertes Ergänzen des Bereichs des digitalen Konstruktionsmodells (K1) des Werkzeugteils (1.1, 1.2) um den Code (F4) der Werkzeug-Codierungssystematik (4), der diesem Bereich des digitalen Konstruktionsmodells (K1) des Werkzeugteils (1.1, 1.2) zugeordnet wurde.
